# EUROPEAN PATENT APPLICATION

(11) **EP 1 158 577 A2**
(43) Date of publication of application: **28.11.2001**
(21) Application number: 01111236.4
(22) Date of filing: 15.05.2001
(51) Int. Cl.: H01L 21/312, C23C 16/40, H01L 21/768

(54) **Method for forming an insulating film with low dielectric constant**

(30) Priority: 24.05.2000 JP 2000153486
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Shioya, Yoshimi, Minato-ku, Tokyo 107-0075 (JP); Ohira, Kouichi, Minato-ku, Tokyo 107-0075 (JP); Maeda, Kazuo, Minato-ku, Tokyo 107-0075 (JP)
(74) Representative: Schwabe - Sandmair - Marx

(57) **Abstract**

The present invention relates to a semiconductor device manufacturing method for forming an interlayer insulating film having a low dielectric constant by coating a copper wiring. In configuration, in a semiconductor device manufacturing method of forming an insulating film 25 having a low dielectric constant on a substrate 21, the insulating film 25 is formed by plasmanizing a film forming gas containing any one oxygen-containing gas of N₂O, H₂O, and CO₂, ammonia (NH₃), and at least one of an alkyl compound having a siloxane bond and methylsilane (SiHₙ(CH₃)₄₋ₙ: n=0, 1, 2, 3) to react.

## Description

### BACKGROUND OF THE INVENTION

### 1. Field of the Invention

The present invention relates to a semiconductor device in which an interlayer insulating film having a low dielectric constant is formed by coating a copper wiring, and a method of manufacturing the same.

### 2. Description of the Prior Art

In recent years, with the progress of the higher integration of the semiconductor integrated circuit device, the higher speed of the data transfer rate is requested. For this reason, the insulating film having the low dielectric constant to give the small RC delay (referred to as a "low dielectric constant insulating film" hereinafter) is employed. For example, there are the SiOF film having the relative dielectric constant of 3.5 to 3.8, the porous SiO₂ film having the relative dielectric constant of 3.0 to 3.1, etc.

In addition, the low dielectric constant interlayer insulating film whose relative dielectric constant is in the order of 2 is needed. In order to form such low dielectric constant interlayer insulating film, the plasma enhanced CVD method employing trimethylsilane (SiH(CH₃)₃) and N₂O has been known as one method. For example, this plasma enhanced CVD method is set forth in M.J.Loboda, J.A. Seifferly, R.F.Schneider, and C.M.Grove: Electrochem. Soc. Fall Meeting Abstracts, p.344 (1998), etc. Also, the plasma enhanced CVD method employing tetramethylsilane (SiH(CH₃)₄) and N₂O is set forth in J.Shi, M.A-Plano, T.Mountsier, and S.Nag; SEMICON Korea Technical Symposium 2000, p.279 (2000), etc.

In addition, the plasma enhanced CVD method employing phenylsilane, etc. has also been known. For example, such method is set forth in K.Endo, K.Shinoda, T.Tatsumi, 46-th Japanese Applied Physics Society Spring Meeting (1999), p.897, N.Matsushita, Y.Morisada, Y.Naito, S.Matsuno, 60-th Japanese Applied Physics Society Fall Meeting (1999), 1p-ZN-9(1999), Y.Uchida, T.Matsuzawa, S.Kanno, M.Matsumura, 4-th Japanese Applied Physics Society Spring Meeting, p.897 (1999), etc.

However, since the low dielectric constant interlayer insulating film formed by the plasma enhanced CVD method employing trimethylsilane (SiH(CH₃)₃) and N₂O contains a large quantity of carbon (C), there is the problem that the working by the etching, etc. is difficult.

Also, in the low dielectric constant interlayer insulating film formed by the plasma enhanced CVD method employing the film forming gas in the prior art, there is the problem that the relative dielectric constant is largely varied when the film forming conditions such as the plasmanizing power, the film forming temperature, etc. are slightly varied, and thus it is difficult to get stably the relative dielectric constant that is in the order of 2.7.

### SUMMARY OF THE INVENTION

It is an object of the present invention to provide a method of forming a low dielectric constant insulating film that can be easily worked by the etching, etc. and can get the relative dielectric constant in the order of 2.7, and a semiconductor device.

In the present invention, an interlayer insulating film having a low dielectric constant is formed by plasmanizing a film forming gas containing any one oxygen- containing gas of N₂O, H₂O, and CO₂, ammonia (NH₃), and at least one of an alkyl compound having a siloxane bond and methylsilane (SiHₙ(CH₃)₄₋ₙ: n=0, 1, 2, 3) to react.

According to the examination, if the insulating film is formed by the plasma enhanced CVD method employing the film forming gas in which the ammonia (NH₃) is added to the mixed gas of the alkyl compound having the siloxane bond and any one oxygen-containing gas of N₂O, H₂O, and CO₂, an amount of oxygen (O) can be controlled finely by adding NH₃, and thus the insulating film in which an amount of carbon (C) is appropriate and the relative dielectric constant of which can be stably obtained in the order of 2.7 can be formed.

Also, it can be found that, even if the insulating film is formed by the plasma enhanced CVD method employing the film forming gas in which the ammonia (NH₃) is added to the mixed gas of the methylsilane (SiHₙ(CH₃)₄₋ₙ: n=0, 1, 2, 3) and any one oxygen-containing gas of N₂O, H₂O, and CO₂, the insulating film in which an amount of carbon (C) is appropriate and the relative dielectric constant of which can be stably obtained in the order of 2.7 can be similarly formed by the action of NH₃.

In addition, it can be found that, even if the insulating film is formed by the plasma enhanced CVD method employing the film forming gas in which the ammonia (NH₃) is added to the mixed gas of the alkyl compound having the siloxane bond, the methylsilane (SiHₙ(CH₃)₄₋ₙ: n=0, 1, 2, 3) and any one oxygen-containing gas of N₂O, H₂O, and CO₂, the insulating film in which an amount of carbon (C) is appropriate and the relative dielectric constant of which can be stably obtained in the order of 2.7 can be similarly formed by the action of NH₃.

As described above, according to the present invention, since the film is formed by the plasma enhanced CVD method employing the film forming gas in which the ammonia (NH₃) is added, the insulating film in which an amount of carbon (C) is appropriate and the relative dielectric constant of which can be stably obtained in the order of 2.7 can be formed.

### BRIEF DESCRIPTION OF THE DRAWINGS

FIGS.1A to 1F are sectional views showing a semiconductor device and a method of manufacturing the same according to a first embodiment of the present invention;
FIG.2 is a graph showing a growth rate of a low dielectric constant insulating film as the first embodiment of the present invention;
FIG.3 is a graph showing characteristics of a relative dielectric constant and a refractive index of the low dielectric constant insulating film as the first embodiment of the present invention;
FIG.4 is a graph showing a characteristic of a leakage current of the low dielectric constant insulating film as the first embodiment of the present invention;
FIG.5 is a sectional view showing a structure of a sample employed in the characteristic examination of the low dielectric constant insulating film as the first embodiment of the present invention;
FIGS.6A and 6B are sectional views showing a semiconductor device and a method of manufacturing the same according to a second embodiment of the present invention; and
FIG.7 is a side view showing a configuration of a plasma film forming apparatus employed in a semiconductor device manufacturing method as embodiments of the present invention.

### DESCRIPTION OF THE PREFERRED EMBODIMENTS

Embodiments of the present invention will be explained with reference to the accompanying drawings hereinafter.

### (First Embodiment)

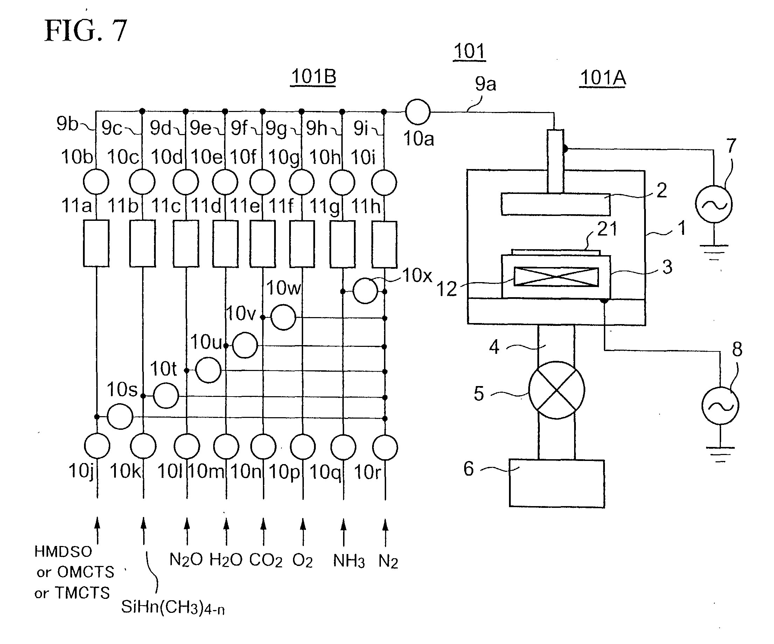

FIG.7 is a side view showing a configuration of a parallel-plate type plasma film forming apparatus 101 employed in a semiconductor device manufacturing method according to embodiments of the present invention.

This plasma film forming apparatus 101 comprises a film forming portion 101A as a place where a barrier insulating film is formed on a substrate 21 by the plasma gas, and a film forming gas supply portion 101B having a plurality of gas supply sources for supplying gases respectively to construct a film forming gas.

As shown in FIG.7, the film forming portion 101A includes a chamber 1 whose pressure can be reduced, and the chamber 1 is connected to an exhausting device 6 via exhaust pipe 4. A switching valve 5 that controls communication/ non-communication between the chamber 1 and the exhausting device 6 is provided in the middle of the exhaust pipe 4. A pressure measuring means such as a vacuum gauge (not shown), etc. that monitors the pressure in the chamber 1 is provided to the chamber 1.

A pair of opposing upper electrode (first electrode) 2 and lower electrode (second electrode) 3 are provided in the chamber 1. A power supply (RF power supply) 7 for supplying the high frequency power having a frequency 13.56 MHz is connected to the upper electrode 2, and also a power supply (LF power supply) 8 for supplying the low frequency power having a frequency 380 kHz is connected to the lower electrode 3. The film forming gas is plasmanized by supplying the power to the upper electrode 2 and the lower electrode 3 from these power supplies 7, 8. The upper electrode 2, the lower electrode 3, and the power supplies 7, 8 constitute a plasma generating means for plasmanizing the film forming gas.

The upper electrode 2 is used commonly as a distributor of the film forming gas. A plurality of through holes are formed in the upper electrode 2, and then opening portions of the through holes formed on a surface opposing to the lower electrode 3 act as discharge ports (inlet ports) of the film forming gas. The discharge ports for the film forming gas, etc. are connected to the film forming gas supply portion 101B via a pipe 9a. Also, as the case may be, a heater (not shown) may be provided to the upper electrode 2. This is because the upper electrode 2 is heated up to the temperature of about 100 to 200 °C during the film formation to prevent the particles consisting of the reaction product such as the film forming gas, etc. from sticking onto the upper electrode 2.

The lower electrode 3 is used commonly as a retaining table of a substrate 21, and has a heater 12 for heating the substrate 21 on the retaining table.

Supply sources for hexamethyldisiloxane (HMDSO: (CH₃)₃Si-O-Si(CH₃)₃), methylsilane (SiHₙ(CH₃)₄₋ₙ) :n=0,1,2,3), nitrogen monoxide (N₂O), water (H₂O), carbon dioxide (CO₂), oxygen (O₂), ammonia (NH₃), and nitrogen (N₂) are provided to the film forming gas supply portion 101B. These gases are supplied appropriately to the chamber 1 of the film forming portion 101A via branch pipes 9b to 9i and the pipe 9a to which all branch pipes 9b to 9f are connected. Flow rate controlling means 11a to 11h and switching means 10b to 10n, 10p and 10r for controlling the open/close of the branch pipes 9b to 9i are provide in the middle of the branch pipes 9b to 9i, and also a switching means 10a for controlling the open/close of the pipe 9a is provided in the middle of the pipe 9a. Also, in order to purge the residual gas in the branch pipes 9b to 9f, and 9h by flowing the N₂ gas, switching means 10s to 10x for controlling the communication/non-communication between the branch pipe 9i connected to the N₂ gas supply source and other branch pipes 9b to 9f, and 9h respectively are provided. In this case, this N₂ gas purges the residual gas in the pipe 9a and the chamber 1 in addition to the branch pipes 9b to 9f, and 9h.

According to the above film forming apparatus 101, there are provided the supply source of the alkyl compound (HMDSO) having a siloxane bond (that is, an Si-O-Si bond), the supply source of the methylsilane (SiHₙ(CH₃)₄₋ₙ):n=0,1,2,3), the oxygen-containing gas supply source, and ammonia (NH3) supply source and also there is provided plasma generating means 2, 3, 7, 8 for plasmanizing the film forming gas.

As a result, the insulating film having appropriate content of carbon and low relative dielectric constant can be formed by the plasma enhanced CVD method. Therefore, as shown in a third embodiment described in the following, the barrier insulating film that has the low dielectric constant and suppresses the diffusion of copper can be formed.

Then, as the plasma generating means, there are a means for generating the plasma by using first and second parallel-plate type electrodes 2, 3, a means for generating the plasma by the ECR (Electron Cyclotron Resonance) method, a means for generating the helicon plasma by radiating the high frequency power from the antenna, etc., for example.

Power supplies 7, 8 for supplying high and low frequency powers respectively are connected to the first and second parallel-plate type electrodes 2, 3 among these plasma generating means. Accordingly, the plasma can be generated by applying these high and low frequency powers to the electrodes 2, 3 respectively. In particular, since the insulating film formed in this manner is dense- and contains CH₃, it has the low dielectric constant.

Then, concerning to the alkyl compound having the siloxane bond, methylsilane and gas containing oxygen as the film forming gas for the interlayer insulating film, to which the present invention is applied, followings can be employed as typical examples.
(i) the alkyl compound having the siloxane bond:
   hexamethyldisiloxane (HMDSO: (CH₃)₃Si-O-Si(CH₃)₃)
   octamethylcyclotetrasiloxane (OMCTS: 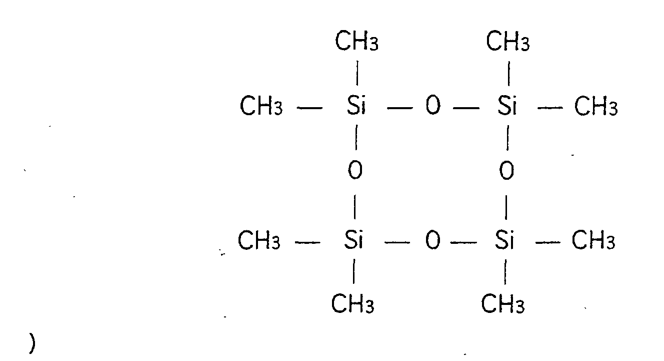
   tetramethylcyclotetrasiloxane(TMCTS: 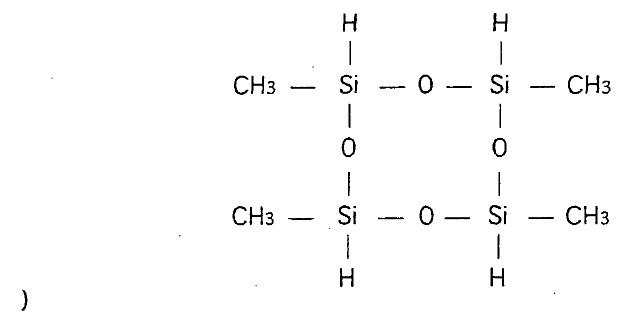
(ii) the methylsilane (SiHₙ(CH₃)₄₋ₙ:n=0,1,2,3)
   monomethylsilane (SiH₃(CH₃))
   dimethylsilane (SiH₂(CH₃)₂)
   trimethylsilane (SiH(CH₃)₃)
   tetramethylsilane (Si(CH₃)₄)
(iii) the gas containing oxygen
   nitrogen monoxide (N₂O)
   water (H₂O)
   carbon dioxide (CO₂)

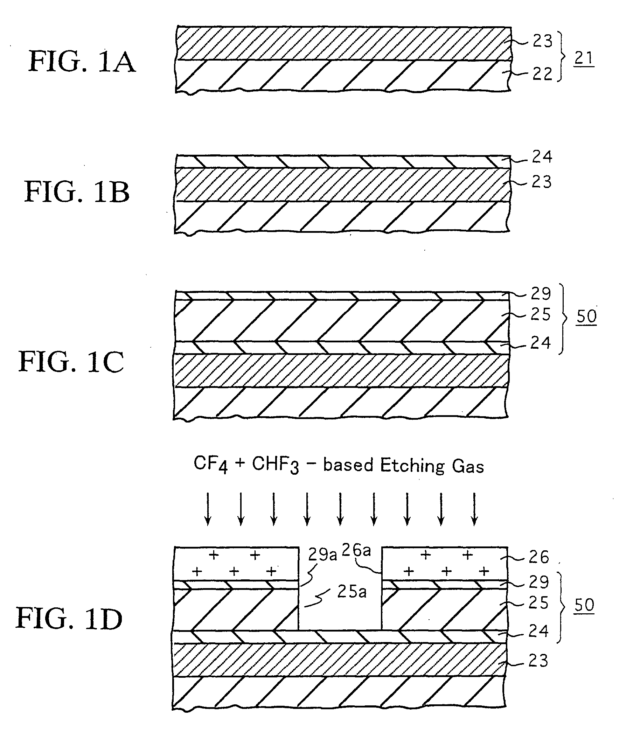

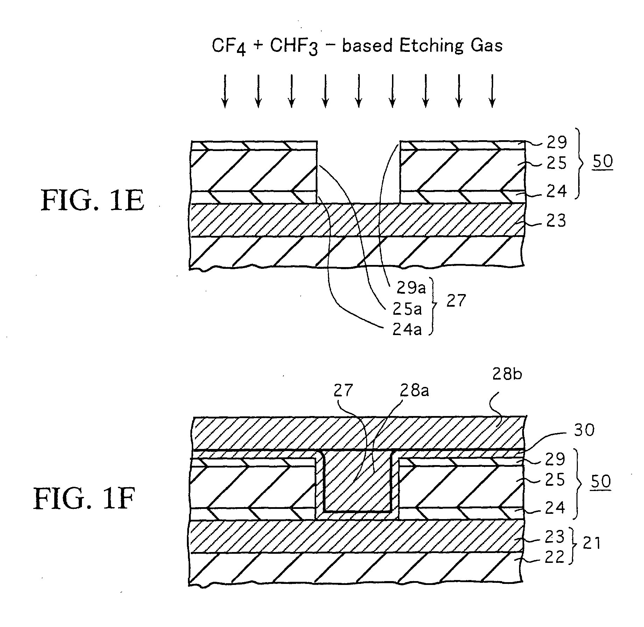

Next, a semiconductor device and a method of manufacturing the same according to the first embodiment of the present invention will be explained with reference to FIG.1 hereinafter.

FIGS.1A to 1F are sectional views showing the semiconductor device and the method of manufacturing the same according to the first embodiment of the present invention.

FIG.1A is a sectional view showing the state after the copper wiring is formed. In FIG.1A, a reference 22 denotes an underlying insulating film, and a reference 23 denotes a copper wiring (lower wiring). These elements constitute a substrate 21.

Then, as shown in FIG.1B, in this state, a barrier insulating film 24 is formed on the copper wiring 23 by the plasma enhanced CVD method. In order to form the barrier insulating film 24, first the substrate 21 is introduced into the chamber 1 of the plasma film forming apparatus 101 and then held into a substrate holder 3. Then, the substrate 21 is heated and the temperature is held at 350 °C. Then, the hexamethyldisiloxane (HMDSO), the N₂O gas, and the CH₄ gas are introduced into the chamber 1 of the plasma film forming apparatus 101 shown in FIG.7 at flow rates of 50 sccm, 30 sccm, and 25 sccm respectively, and the pressure is kept at 1 Torr.

Then, a power of 100 W having a frequency of 380 kHz is applied to the lower electrode 3. No power is applied to the upper electrode 2. An interval between the upper electrode 2 and the lower electrode 3 is set to less than 30 mm, preferably less than 25 mm. Also, as the case may be, the upper electrode 2 is heated up to the temperature of about 100 to 200 °C to prevent the sticking of the reaction product.

Accordingly, the hexamethyldisiloxane and the N₂O are plasmanized. The barrier insulating film 24 made of an insulating film having a thickness of about 50 nm and containing Si, O, C, H is formed by holding this state for a predetermined time. According to the examination, the formed insulating film containing Si, O, C, H has a relative dielectric constant of about 3.2, when measured at the frequency of 1 MHz, and a leakage current of 10⁻⁸ A/cm², when the electric field strength of 3 MV/cm is applied.

Then, as shown in FIG.1C, a silicon containing insulating film 25 having the low dielectric constant and having a thickness of about 500 nm is formed by the well-known plasma enhanced CVD method. In order to form the silicon containing insulating film 25, in the state that the substrate 21 is held at the temperature of 350 °C , subsequently the hexamethyldisiloxane (HMDSO), the N₂O gas, and the NH₃ gas are introduced into the chamber 1 of the plasma film forming apparatus 101 shown in FIG.7 at flow rates of 50 sccm, 200 sccm, and x sccm respectively, and the pressure is kept at 1.75 Torr. In order to compare and check how the characteristic of the formed silicon containing insulating film 25 changes in answer to the change of the NH₃ gas flow rate, the NH₃ gas flow rate (x sccm) is changed in the range of 0 to 200 sccm.

Then, the high frequency power 300 W having a frequency of 13.56 MHz is applied to the upper electrode 2. No power is applied to the lower electrode 3. In this case, the interval between the upper electrode 2 and the lower electrode 3 is set to more than 20 mm, preferably more than 25 mm.

Then, an NSG film (silicon oxide film not containing the impurity) or an SiOC containing insulating film which both are thin and highly dense is formed as a protection film 29 for the silicon containing insulating film 25 against the ashing and the etching. The insulating films 24, 25, 29 constitute an interlayer insulating film 50.

If the protection film 29 is not formed, there is such a possibility that the silicon containing insulating film 25 is altered in quality by the processing gas when the ashing of a photoresist film 26 is executed or the etching of the barrier insulating film 24 formed under the silicon containing insulating film 25 is executed, and thus the silicon containing insulating film 25 is degraded in the low dielectric constant characteristic.

Then, as shown in FIG.1D, the photoresist film 26 is formed, and then an opening portion 26a is formed in the photoresist film 26 in the via-hole forming area by patterning the photoresist film 26. Then, the protection film 29 and the interlayer insulating film 25 are etched to be removed via the opening portion 26a in the photoresist film 26 by the reactive ion etching (RIE) using the plasmanized mixed gas containing CF₄+CHF₃. Accordingly, opening portions 29a and 25a are formed to expose the barrier insulating film 24. Then, the ashing of the photoresist film 26 is executed. At this time, the barrier insulating film 24 has the etching resistance against the etching gas for the protection film 29 and the interlayer insulating film 25 and the ashing gas for the photoresist film 26. As a result, the copper wiring 23 is not badly affected by the etching gas. The concentration of the mixed gas containing CF₄+CHF₃ may be adjusted by adding Ar+O₂, etc. to CF₄+CHF₃.

Then, as shown in FIG.1E, the barrier insulating film 24 is etched to be removed via the opening portion 29a in the protection film 29 and the opening portion 25a in the interlayer insulating film 25 by the reactive ion etching (RIE) using the plasmanized mixed gas containing CF₄+CHF₃. The mixed gas containing CF₄+CHF₃ employed in the reactive ion etching (RIE), compared with the mixed gas employed in etching the protection film 29 and the silicon containing insulating film 25, is changed in composition ratio. Accordingly, an opening portion 24a is formed in the barrier insulating film 24, and thus a via hole 27 is formed in the interlayer insulating film 50 to expose the copper wiring 23 on its bottom. At this time, the copper wiring 23 has the etching resistance against the etching gas for the above barrier insulating film 24. As a result, the copper wiring 23 is not badly influenced by the etching gas. In this case, a surface of the copper wiring is oxidized, but such oxidized surface of the copper wiring may be removed by exposing to the reducing gas, e.g., the hydrogen plasma which is diluted by the NH₃ gas or the inert gas such as argon, nitrogen, or the like, after the etching step of the barrier film.

Then, as shown in FIG.1F, a conductive film, e.g., an underlying conductive film 30 consisting of a barrier metal film such as tantalum nitride (TaN) or the like and a copper film formed by the sputter method is provided in the via hole 27. Then, a copper film 28a is buried on the underlying conductive film 30 and in the via hole 27. Then, an upper wiring 28b made of copper or aluminum is formed to be connected to the underlying wiring 23 via the copper film 28a.

With the above, the formation of the upper wiring 28b that is connected to the underlying wiring 23 through the via hole 27 formed in the interlayer insulating film 50 can be completed.

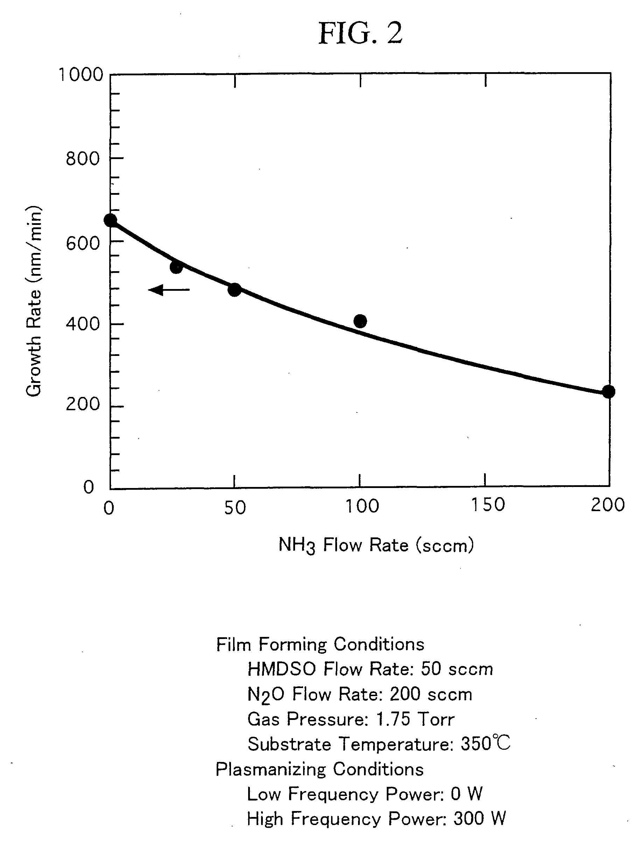

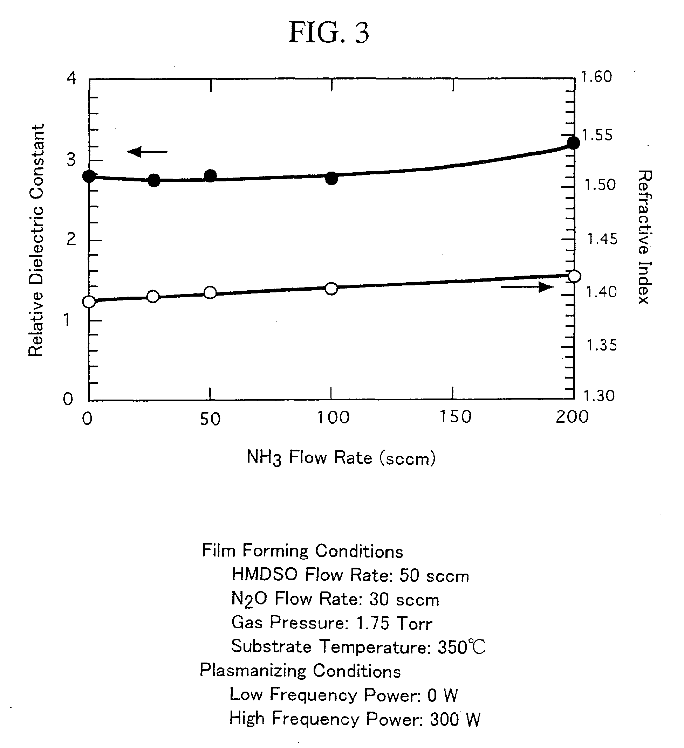

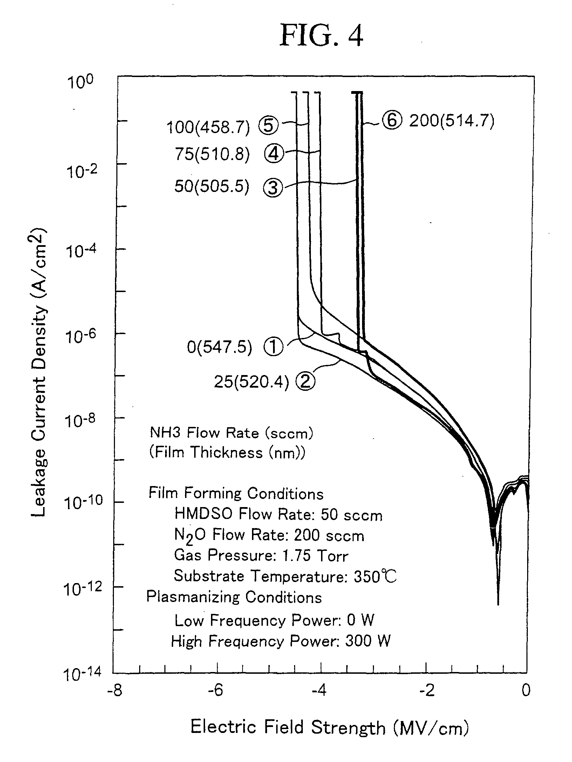

Next, the examination results of characteristics of the barrier insulating film formed according to the above semiconductor device manufacturing method will be explained with reference to FIG.2 to FIG.4 hereunder. FIG.2 is a graph showing a growth rate of the silicon containing insulating film. FIG.3 is a graph showing behaviors of change of the relative dielectric constant and the refractive index of the silicon containing insulating film with respect to the change of the NH₃ flow rate. FIG.4 is a graph showing the examination of the leakage current flowing between the electrode and the substrate, that sandwich the silicon containing insulating film between them.

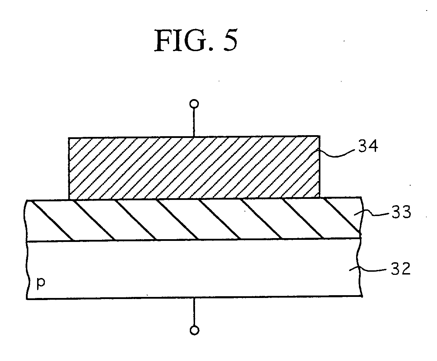

FIG.5 is a sectional view showing a structure of a sample employed in the above examination. This sample is formed as follows. That is, as shown in FIG.5, a silicon containing insulating film 33 is formed on a p-type silicon substrate 32 by the plasma enhanced CVD method using HMDSO, N₂O, and NH₃ as the film forming gas. Film forming conditions of the silicon containing insulating film 33 will be given in the following.
(i) Film forming conditions
   HMDSO flow rate: 50 sccm
   N₂O flow rate: 30 sccm
   NH₃ flow rate: 0, 25, 50, 75, 100, 200 sccm
   gas pressure: 1.75 Torr
   substrate heating temperature: 350 °C
(ii) plasmanizing conditions
   high frequency power (13.56 MHz) P_{HF}: 300 W
   low frequency power (380 kHz) P_{LF}: 0 W
   interval between the upper electrode and the lower electrode: more than 20 mm, preferably more than 25 mm

The film thickness of the silicon containing insulating film 33 was 547.5 nm, 505.5 nm, 510.8 nm, 458.7 nm, and 514.7 nm with respect to the NH₃ flow rate of 0, 25, 50, 75, 100, and 200 sccm respectively.

In addition, a mercury probe 34 is brought into contact with the surface of the low dielectric constant insulating film 33. An electrode area of the mercury probe 34, which contacts to the low dielectric constant insulating film 33, is 0.0230 cm².

The C-V measuring method in which the high frequency signal of 1 MHz is superposed on the DC bias is employed when a relative dielectric constant is measured, and the He-Ne laser whose wavelength is 6338 in the ellipsometer is employed when a refractive index is measured. Also, when the leakage current is measured, the silicon substrate 32 is grounded and also the negative voltage is applied to the mercury probe 34.

The measured result of the growth rate of the silicon containing insulating film 33 is shown in FIG.2. In FIG.2, an ordinate denotes the growth rate (nm/min) represented in a linear scale, and an abscissa denotes the NH₃ flow rate (sccm) represented in a linear scale. As shown in FIG.2, the growth rate is about 640 nm/min at the NH₃ flow rate of 0 sccm, and subsequently decreased with the increase of the NH₃ flow rate, and is about 200 nm/min at the NH₃ flow rate of 200 sccm.

The measured results of the relative dielectric constant and the refractive index of the low dielectric constant insulating film are shown in FIG.3. In FIG.3, a left side ordinate denotes the relative dielectric constant represented in a linear scale, and a right side ordinate denotes the refractive index represented in a linear scale. An abscissa denotes the NH₃ flow rate (sccm) represented in a linear scale. As shown in FIG.3, the relative dielectric constant is about 2.7 when the NH₃ flow rate is 0 sccm and about 3.1 when the NH₃ flow rate is 200 sccm, and is increased with the increase of the NH₃ flow rate. Also, the refractive index exhibits the same tendency, and is about 1.39 when the NH₃ flow rate is 0 sccm, and is about 1.42 when the NH₃ flow rate is 200 sccm.

The measured result of the leakage current of the low dielectric constant insulating film 33 is shown in FIG.4. In FIG.4, an ordinate denotes the leakage current density (A/cm²) represented in a logarithmic scale, and an abscissa denotes an electric field strength (MV/cm) that is applied to the silicon containing insulating film 33 and represented in a linear scale. Symbols 1 to 6 are labeled to the samples having the different NH₃ flow rate respectively while using the NH₃ flow rate as the parameter. Also, the numeral in the parenthesis after the numeral indicating the flow rate (sccm) denotes the film thickness (nm). In this case, a negative sign of the abscissa indicates that the negative potential is applied to the mercury probe 34.

As shown in FIG.4, the leakage current is reduced as the NH₃ flow rate is lowered. It is preferable that the leakage current should be suppressed lower than 10⁻¹⁰ A/cm² at the electric field strength of 1 MV/cm in practical use.

Further, according to another examination, the density of the normal SiO₂ film is almost 2.2 g/cm³, whereas the density of the film formed according to the first embodiment is almost 1.3 g/cm³. This signifies that the film is porous and an amount of carbon is reduced.

As described above, according to the first embodiment of the present invention, the silicon containing insulating film 25 as a main film of the interlayer insulating film 50 by plasmanizing the film forming gas containing the alkyl compound having the siloxane bond, N₂O (oxygen- containing gas), and NH₃ to react.

Since NH₃ is contained in the film forming gas, an amount of contained carbon in the film can be reduced rather than the case where no NH₃ is contained. Also, the silicon containing insulating film whose relative dielectric constant is in the order of 2.7 and has small variation of the relative dielectric constant can be stably formed.

In the above, HMDSO is employed as the silicon compound that contains only silicon (Si), oxygen (O), carbon (C), and hydrogen (H). But the other silicon compound mentioned above, e.g., octamethylcyclotetrasiloxane (OMCTS) or tetramethylcyclotetrasiloxane (TMCTS) may be employed.

Also, N₂O is employed as the oxygen-containing gas. But the water (H₂O) or the carbon dioxide (CO₂) may be employed.

In addition, the interlayer insulating film of the present invention is applied to the copper wiring. But the present invention may be applied to the aluminum wiring, and others.

### (Second Embodiment)

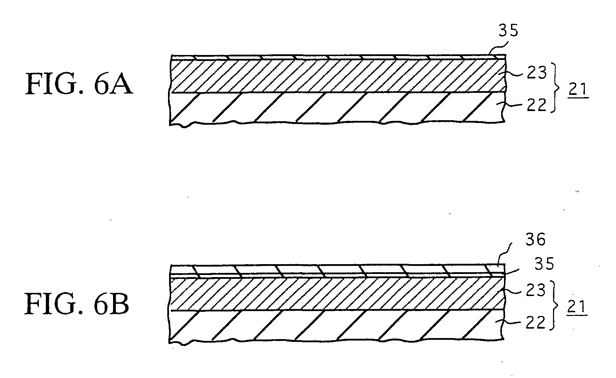

FIGs.6A, 6B is a sectional view showing a semiconductor device and a method of manufacturing the same according to a second embodiment of the present invention.

A difference from the first embodiment of the present invention shown in FIG.1 is to employ the film forming gas in which tetramethylsilane (Si(CH₃)₄) as methylsilane is added to the above silicon compound, N₂O, and NH₃. In addition, other differences reside in that the low frequency power is applied to the lower electrode 3, that holds the substrate, out of the parallel-plate type opposing electrodes, and that the high frequency AC power is also applied to the upper electrode 2 that opposes to the lower electrode 3.

The film forming conditions for the silicon containing film emploting the plasma enhanced CVD method using this film forming gas are shown hereunder. The silicon containing film has the low dielectric constant, and is formed as a main film of the interlayer insulating film.

First, as shown in FIG.6A, the copper wiring 23 and the barrier insulating film 35 for covering this copper wiring 23 are formed on the underlying insulating film 22. Then, HMDSO, the N₂O gas, the NH₃ gas, and tetramethylsilane (Si(CH₃)₄) are introduced into the chamber 1 of the plasma film forming apparatus 101 shown in FIG.7, and then the low dielectric constant insulating film 36 is formed on the barrier insulating film 35 by the plasma enhanced CVD method, as shown in FIG.6B.

More particularly, the HMDSO, the N₂O gas, the NH₃ gas, and tetramethylsilane (Si(CH₃)₄) are introduced into the chamber 1 of the plasma film forming apparatus 101 shown in FIG.7 at the flow rates of 50 sccm, 200 sccm, 25 sccm, and 25 sccm respectively, and then the gas pressure in the chamber 1 can be maintained at 1.75 Torr. Then, the high frequency power 300 W having the frequency of 13.56 MHz is applied to the upper electrode 2 of the parallel-plate type opposing electrodes. No power is applied to the lower electrode 3 that opposes to the upper electrode 2.

Accordingly, since the film forming gas is plasmanized, the low dielectric constant insulating film 36 of 500 nm thickness is formed by holding this state for 50 seconds to cover the copper wiring 23.

According to another examination, in the formed low dielectric constant insulating film 36, the relative dielectric constant is 2.7, and the leakage current is in the order of 10⁻¹⁰ A/cm² at the electric field strength of 1 MV/cm.

As described above, according to the second embodiment of the present invention, unlike the first embodiment, the film forming gas in which tetramethylsilane (Si(CH₃)₄) is added to the alkyl compound having the siloxane bond, N₂O, and NH₃ is employed. Accordingly, since the dense insulating film having the low dielectric constant can be formed, the silicon containing insulating film 25 having the relative dielectric constant that is in the order of 2.7 can be formed stably as the main film of the interlayer insulating film 50.

In the second embodiment, the tetramethylsilane (Si(CH₃)₄) is employed as the methylsilane. But any one of monomethylsilane (SiH₃(CH₃)), dimethylsilane (SiH₂(CH₃)₂), and trimethylsilane (SiH(CH₃)₃) may be employed.

With the above, the present invention is explained in detail based on the embodiments. But the scope of the present invention is not limited to the examples shown particularly in the above embodiments, and modifications of the above embodiment without departing from the gist of the present invention may be contained in the scope of the invention.

As described above, according to the present invention, the insulating film as the main film of the interlayer insulating film is formed by the plasma enhanced CVD method employing the film forming gas in which the ammonia (NH₃) is added to the mixed gas that consists of at least one selected from the group consisting of the alkyl compound having the siloxane bond and the methylsilane (SiHₙ(CH₃)₄₋ₙ: n=0, 1, 2, 3), and any one oxygen-containing gas slected from the group consisting of N₂O, H₂O, and CO₂.

Since an amount of oxygen (O) can be controlled finely by adding NH₃, the insulating film in which an amount of carbon (C) is appropriate and the relative dielectric constant of which can be stably obtained in the order of 2.7 can be formed.

## Claims

1. A semiconductor device manufacturing method of forming an insulating film (25, 36) having a low dielectric constant on a substrate (21),
wherein the insulating film (25, 36) is formed by plasmanizing a film forming gas containing at least one selected from the group consisting of an alkyl compound having a siloxane bond and methylsilane (SiHₙ(CH₃)₄₋ₙ: n=0, 1, 2, 3), any one oxygen-containing gas selected from the group consisting of N₂O, H₂O and CO₂, and ammonia (NH₃) to react.

2. A semiconductor device manufacturing method according to claim 1, wherein the methylsilane (SiHₙ(CH₃)₄₋ₙ: n=0, 1, 2, 3) is any one selected from the group consisting of monomethylsilane (SiH₃(CH₃)), dimethylsilane (SiH₂(CH₃)₂), trimethylsilane (SiH(CH₃)₃), and tetramethylsilane (Si(CH₃)₄).

3. A semiconductor device manufacturing method according to claim 1, wherein the alkyl compound having the siloxane bond (Si-O-Si bond) is any one selected from the group consisting of hexamethyldisiloxane (HMDSO: (CH₃)₃Si-O-Si(CH₃)₃), octamethylcyclotetrasiloxane (OMCTS: 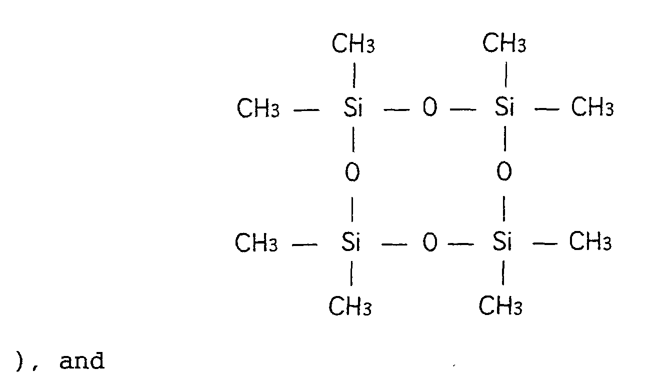 tetramethylcyclotetrasiloxane (TMCTS:

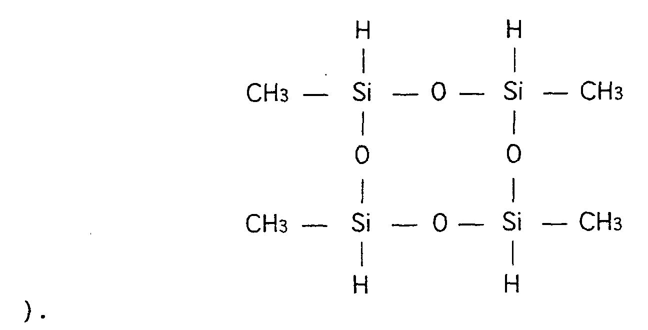

4. A semiconductor device manufacturing method according to claim 1, wherein parallel-plate type electrodes (2, 3) one of which holds the substrate (21) are employed as a plasma generating means, and an AC power of a frequency of 100 kHz to 1 MHz is applied to the electrode (3) that holds the substrate (21), in forming the film.

5. A semiconductor device manufacturing method according to claim 4, wherein an interval between the electrodes (2, 3) is set to more than 20 mm.

6. A semiconductor device manufacturing method according to claim 1, wherein parallel-plate type electrodes (2, 3) one of which holds the substrate (21) are employed as a plasma generating means, and an AC power of a frequency of more than 1 MHz is applied to the electrode (2) opposing to the electrode (3) that holds the substrate (3), in forming the film.

7. A semiconductor device manufacturing method according to claim 6, wherein an interval between the electrodes (2, 3) is set to more than 20 mm.

8. A semiconductor device manufacturing method according to claim 1, wherein a copper wiring (23) is exposed from a surface of the substrate (21), a barrier insulating film (24, 35) is formed to cover the copper wiring (23) and to come to contact with the copper wiring (23), and then the insulating film (25, 36) is formed on the barrier insulating film (24, 35).

9. A semiconductor device in which an interlayer insulating film, that consists of at least a barrier insulating film (24, 35) that comes into contact with a copper wiring (23) and an insulating film (25, 36) formed on the barrier insulating film (24, 35), is formed on the copper wiring (23),
wherein the insulating film having a low dielectric constant, that is formed by the semiconductor device manufacturing method set forth in any one of claims 1 to 8, is employed as the insulating film (25, 36) formed on the barrier insulating film (24, 35) out of the interlayer insulating film.

10. A semiconductor device according to claim 9, wherein a copper wiring (28b) is further formed on the interlayer insulating film (50).
